# EUROPÄISCHE PATENTSCHRIFT

(11) **EP 2 612 374 B1**
(45) Veröffentlichungstag und Bekanntmachung des Hinweises auf die Patenterteilung: **25.03.2015**
(21) Anmeldenummer: 11769798.7
(22) Anmeldetag: 02.09.2011
(51) Int. Cl.: H01L 41/053, H01L 41/25

(54) **VERFAHREN ZUR KONTROLLE VON BIEGESCHWINGUNGEN EINES PIEZOAKTUATORS**
METHOD FOR MONITORING FLEXURAL VIBRATIONS OF A PIEZOACTUATOR
PROCÉDÉ POUR CONTRÔLER DES VIBRATIONS DE FLEXION D'UN ACTIONNEUR PIÉZOÉLECTRIQUE

(30) Priorität: 03.09.2010 DE 102010036257
(43) Veröffentlichungstag der Anmeldung: 10.07.2013
(73) Patentinhaber: Epcos AG, 81669 München (DE)
(72) Erfinder: GABL, Reinhard, 6330 Kufstein (AT)
(74) Vertreter: Epping - Hermann - Fischer
(86) Internationale Anmeldenummer: PCT/EP2011/065238
(87) Internationale Veröffentlichungsnummer: WO 2012/028735

(56) Entgegenhaltungen:
- WO-A1-99/40408
- WO-A1-2009/138422
- DE-A1-102004 016 196
- US-B1- 6 246 151
- ZICKGRAF B ET AL: "Fatigue behaviour of multilayer piezoelectric actuators", ISAF '94. IEEE INTERNATIONAL SYMPOSIUM ON APPLICATIONS OF FERROELECTRICS, 7-10 AUGUST 1994, UNIVERSITY PARK, PA, USA, 1994, Seiten 325-328, XP000553145, ISBN: 0-7803-1847-1
- BOWEN C R ET AL: "Impedance spectroscopy of piezoelectric actuators", SCRIPTA MATERIALIA, Bd. 42, Nr. 8, 2000, Seiten 813-818, XP004326022, ISSN: 1359-6462, DOI: 10.1016/S1359-6462(00)00300-6

## Beschreibung

Die vorliegende Erfindung betrifft eine Methode zur Kontrolle von Biegeschwingungen in einem montierten Piezoaktuator und/oder zur Montage von Piezoaktuatoren, mit der das Auftreten von Biegeschwingungen in dem Piezoaktuator möglichst vermieden wird.

Ein piezoelektrischer Aktor, auch als Piezoaktor oder Piezoaktuator bezeichnet, ist mit piezoelektrischem Material aufgebaut und dient als mechanischer Antrieb zur Erzeugung einer Bewegung, indem mittels einer elektrischen Spannung eine Abmessung, speziell die Länge, des Piezoaktuators verändert wird. Ein Piezoaktuator ist typischerweise als Piezostapel aufgebaut, in dem Schichten eines piezoelektrischen Materiales alternierender Polarisationsrichtungen mit Elektroden aus Metall abwechseln. Die Elektroden sind in der Reihenfolge ihrer Anordnung abwechselnd mit einer von zwei Außenelektroden verbunden.

Eine an die Außenelektroden angelegte elektrische Wechselspannung erzeugt eine Longitudinalschwingung in der Längsrichtung des Piezostapels, das heißt, in der Richtung, in der die Schichten des Piezostapels aufeinander folgen. Eine Longitudinalschwingung des Piezoaktuators wird bei einer Vielzahl von Anwendungen genutzt, zum Beispiel zum Zweck einer Treibstoffinjektion. Hierfür wird der Piezostapel in seiner Längsrichtung zwischen Halterungen oder Aufnahmekomponenten montiert. Es treten üblicherweise eine oder mehrere Resonanzfrequenzen auf, bei denen die angeregte Longitudinalschwingung besonders stark ist.

Ebenfalls auftretende Transversalschwingungen sind dagegen unerwünscht, weil sie Verbiegungen des Piezoaktuators bewirken, die die Funktion des Piezoaktuators beeinträchtigen und gegebenenfalls schädliche Risse in den Randflächen des Piezostapels verursachen. Die Resonanzfrequenzen der Transversalschwingungen sind in der Regel wesentlich niedriger als die Resonanzfrequenzen der Longitudinalschwingungen. Beispielsweise liegt die Resonanzfrequenz der Longitudinalschwingung bei einem 30-mm-Piezoaktuator typisch bei etwa 12 kHz, während Transversalschwingungen je nach Montage des Piezoaktuators bereits bei 2 kHz bis 3 kHz auftreten können und von Signalen relativ niedriger Frequenz angeregt werden.

Aufgrund der üblicherweise vorhandenen Symmetrie im Aufbau eines Piezoaktuators sollten idealerweise keine Transversalschwingungen auftreten, wenn der Piezoaktuator symmetrisch in Halterungen montiert ist. In der Praxis kann jedoch eine kleine Unsymmetrie in der Montage des Piezoaktuators und eine daraus resultierende mechanische Verspannung nicht immer ausgeschlossen werden. Zudem kann eine Unsymmetrie innerhalb des Piezoaktuators auf Grund von Fertigungstoleranzen vorhanden sein, was ebenfalls das Auftreten von Transversalschwingungen begünstigt.

Bei der Montage oder Assemblierung wird durch Messungen der geometrischen Ausrichtung des Piezoaktuators in den Halterungen für eine möglichst symmetrische Montage gesorgt. Damit ist es allerdings nicht möglich, eine in dem Piezoaktuator selbst vorhandene Unsymmetrie auszugleichen. Zudem lässt dieses Montageverfahren keine Beurteilung der tatsächlichen Neigung des Piezoaktuators zu Biegeschwingungen zu. Auf diese Weise ist es ebenfalls nicht möglich, das Auftreten von Biegeschwingungen im Betrieb des Piezoaktuators, insbesondere längere Zeit nach der ersten Inbetriebnahme, zu kontrollieren, was zum Beispiel bei einem Piezoaktuator, der in einem für ein Kraftfahrzeug vorgesehenen Motor eingebaut ist, erwünscht sein kann.

Aufgabe der vorliegenden Erfindung ist es, eine Methode zur Kontrolle und, falls möglich, Vermeidung von Biegeschwingungen in einem piezoelektrischen Aktuator anzugeben, die bei der Montage oder im Betrieb des Aktuators vorteilhaft eingesetzt werden kann.

Diese Aufgabe wird mit dem Verfahren mit den Merkmalen des Anspruches 1 gelöst. Ausgestaltungen ergeben sich aus den abhängigen Ansprüchen.

Bei dem Verfahren zur Kontrolle von Biegeschwingungen eines Piezoaktuators wird ein Kleinsignalspektrum eines zur Anregung von Longitudinalschwingungen vorgesehenen und montierten Piezoaktuators gemessen und aus Resonanzen, die in dem Kleinsignalspektrum auftreten, eine Anregung einer Transversalschwingung in dem Piezoaktuator erfasst.

Bei einer Anwendung des Verfahrens zur Montage eines Piezoaktuators wird der Piezoaktuator in der Längsrichtung, in der die Longitudinalschwingungen durch Anlegen einer Wechselspannung angeregt werden können, zwischen Halterungen montiert. Diese Halterungen sind Elemente, zum Beispiel Teile einer Vorrichtung, mit denen der Piezoaktuator mechanisch verbunden wird und auf die eine im Betrieb des Piezoaktuators erzeugte Bewegung übertragen wird.

Ein Kleinsignalspektrum des montierten Piezoaktuators wird in einem Frequenzbereich gemessen, und aus Resonanzen, die in dem Kleinsignalspektrum erkennbar sind, wird ein Auftreten einer Transversalschwingung in dem Piezoaktuator erfasst. Falls eine unerwünscht starke Transversalschwingung erkennbar ist, wird die Montage des Piezoaktuators geändert, zum Beispiel durch eine Justierung, wobei vorzugsweise hauptsächlich diejenigen Parameter geändert werden, die sich vorrangig auf die Neigung zu Transversalschwingungen auswirken. Die Messung und die Änderung der Montage werden nach Bedarf so oft wiederholt, bis aus den Schwingungsresonanzen in dem Kleinsignalspektrum hervorgeht, dass keine Transversalschwingung auftritt oder dass auftretende Transversalschwingungen oder Biegeschwingungen unterhalb einer vorgegebenen Grenze, insbesondere unterhalb einer vorgegebenen maximalen Amplitude, liegen.

Eine ausreichende Verminderung der Transversalschwingungen kann insbesondere festgestellt werden, indem überprüft wird, ob Schwingungsresonanzen in dem Kleinsignalspektrum allenfalls in einem vorgegebenen minimalen Frequenzabstand auftreten. Statt dessen oder zusätzlich kann überprüft werden, ob wesentliche Schwingungsresonanzen in dem Kleinsignalspektrum nur oberhalb einer vorgegebenen minimalen Frequenz auftreten, die vorab so bestimmt wird, dass oberhalb dieser minimalen Frequenz im Wesentlichen keine Transversalschwingungen auftreten.

Montageparameter, die für das Auftreten von Transversalschwingungen relevant sein können, sind beispielsweise die Position des Piezoaktuators in den Halterungen, insbesondere der Winkel zwischen der Längsrichtung des Piezoaktuators und der Ausrichtung der Halterungen, und die Stärke und Richtung der von den Halterungen auf den Piezoaktuator ausgeübten mechanischen Spannung.

Dieses Verfahren zur Kontrolle von Biegeschwingungen eines Piezoaktuators beruht darauf, dass der Piezoaktuator als Sensor eingesetzt werden kann, weil mit einem derartigen piezoelektrischen Bauelement elektrische Signale in mechanische Bewegungen und mechanische Bewegungen in elektrische Signale überführt werden können. Als Kleinsignalspektrum kann insbesondere der absolute Betrag der Impedanz des Piezoaktuators in Abhängigkeit von der Frequenz bestimmt werden. Das Impedanzspektrum eines Piezoaktuators weist im Bereich einer mechanischen Eigenschwingung typischerweise eine Serienresonanz und eine bei einer etwas höheren Frequenz auftretende Parallelresonanz auf.

Unter einer Serienresonanz versteht man die Resonanz einer Reihenschaltung einer Kapazität und einer Induktivität. Wenn durch diese Reihenschaltung ein Wechselstrom fließt, treten an der Kapazität und an der Induktivität um 90° gegensinnig zueinander phasenverschobene Spannungen auf. Bei einer Resonanzfrequenz sinkt die Impedanz dieser Reihenschaltung theoretisch auf null und praktisch - bedingt durch den stets vorhandenen ohmschen Widerstand - auf ein lokales Minimum. Unter einer Parallelresonanz versteht man die Resonanz einer Parallelschaltung einer Kapazität und einer Induktivität. Bei einer Resonanzfrequenz wird die Impedanz dieser Parallelschaltung theoretisch unendlich groß und nimmt praktisch - bedingt durch den stets vorhandenen ohmschen Widerstand - ein lokales Maximum an.

Wenn die Impedanz eines montierten Piezoaktuators als Funktion der Frequenz gemessen wird, sind die elektromechanischen Eigenschwingungen der gesamten Anordnung des montierten Piezoaktuators und der Halterungen erkennbar. Mechanische Schwingungen, die wie bei einem Piezoaktuator elektrisch koppeln, können auf diese Weise unmittelbar detektiert werden. Wenn die Anordnung Eigenschwingungen aufweist, erhält man ein Impedanzspektrum mit jeweils einer Frequenz der Serienresonanz und einer Frequenz der Parallelresonanz in dem für die betreffende Eigenschwingung charakteristischen Frequenzbereich. Aus einer Messung der Kleinsignalimpedanz kann daher das Schwingungsverhalten des montierten Piezoaktuators, insbesondere das Auftreten einer Biegeschwingung, bestimmt werden. Die Messung und Auswertung des Kleinsignalspektrums kann unter Einsatz eines elektronischen Regelkreises durchgeführt werden. Durch eine Veränderung der Montage des Piezoaktuators anhand der in dem Kleinsignalspektrum auftretenden Resonanzen kann gegebenenfalls eine Optimierung erreicht werden, so dass Biegeschwingungen kaum noch auftreten und im Idealfall nicht mehr vorhanden sind.

Ein Vorteil dieses Verfahrens liegt darin, dass dabei unmittelbar das Schwingungsverhalten des Piezoaktuators erfasst wird und - im Unterschied zu einer nur auf die geometrische Optimierung der Position des Piezoaktuators in den Halterungen zielenden Methode - auch eine Unsymmetrie innerhalb des Piezoaktuators berücksichtigt wird. Biegeschwingungen können daher wirkungsvoller als bisher vermieden werden.

Es folgt eine genauere Beschreibung von Beispielen des Verfahrens anhand der beigefügten Figuren.

Die Figur 1 zeigt eine schematische Anordnung eines montierten Piezoaktuators.

Die Figur 2 zeigt ein Flussdiagramm zu einem Ausführungsbeispiel des Verfahrens, das zur Montage eines Piezoaktuators eingesetzt wird.

Die Figur 3 zeigt ein Diagramm eines Impedanzspektrums.

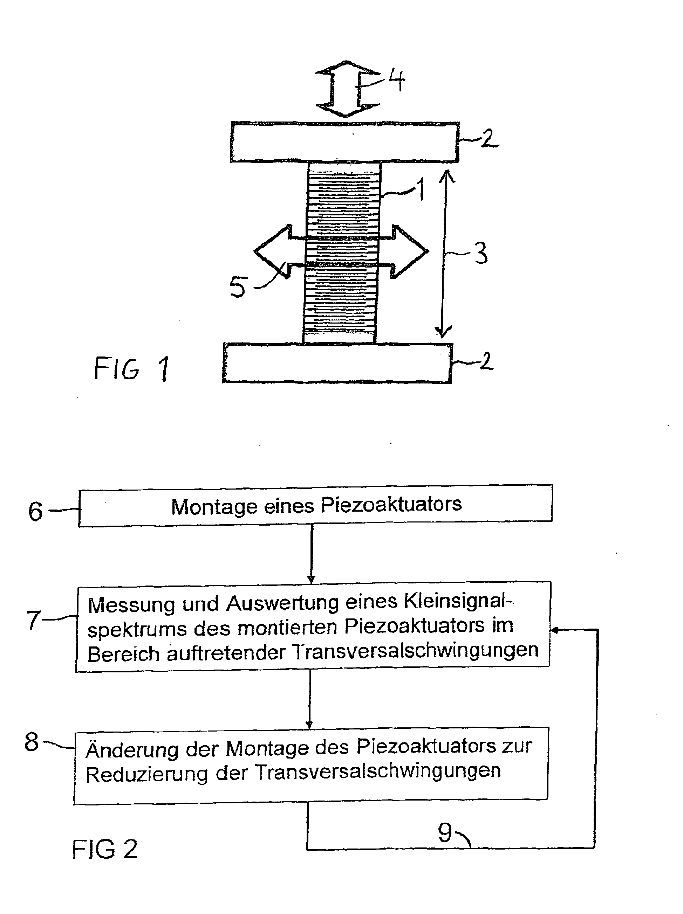

Die Figur 1 zeigt eine schematische seitliche Ansicht einer Anordnung eines montierten Piezoaktuators 1 zwischen Halterungen 2. Die Halterungen 2 können zum Beispiel Teile einer Vorrichtung sein. Der Piezoaktuator 1 wird in einer Längsrichtung 3 ausgerichtet, in der die Longitudinalschwingungen 4 angeregt werden können, die für die vorgesehene Anwendung des Piezoaktuators 1 erforderlich sind. Transversalschwingungen 5 können quer zu der Richtung der Longitudinalschwingungen 4 auftreten und zu unerwünschten oder schädlichen Verbiegungen des Piezoaktuators 1 führen.

Um die Transversalschwingungen möglichst zu eliminieren, wird insbesondere bei der Montage des Piezoaktuators das Verfahren mit den Verfahrensschritten gemäß dem Flussdiagramm der Figur 2 angewendet. In einem ersten Verfahrensschritt 6 erfolgt die Montage des Piezoaktuators. In einem zweiten Verfahrensschritt 7 erfolgt die Messung und Auswertung eines Kleinsignalspektrums des montierten Piezoaktuators im Bereich möglicher auftretender Transversalschwingungen. In einem darauf folgenden oder gleichzeitig mit dem zweiten Verfahrensschritt 7 durchgeführten dritten Verfahrensschritt 8 erfolgt die Änderung der Montage des Piezoaktuators zur Reduzierung der Transversalschwingungen, insbesondere die Justage oder Nachregelung von Montageparametern, bis eine Sollvorgabe für das Impedanzspektrum erreicht ist. Durch die Wiederholung 9 des zweiten Verfahrensschrittes 7 und des dritten Verfahrensschrittes 8 kann eine Optimierung vorgenommen werden, so dass schließlich ein tolerierbares Minimum an Biegeschwingungen erreicht wird oder im Idealfall die Biegeschwingungen vollständig eliminiert werden.

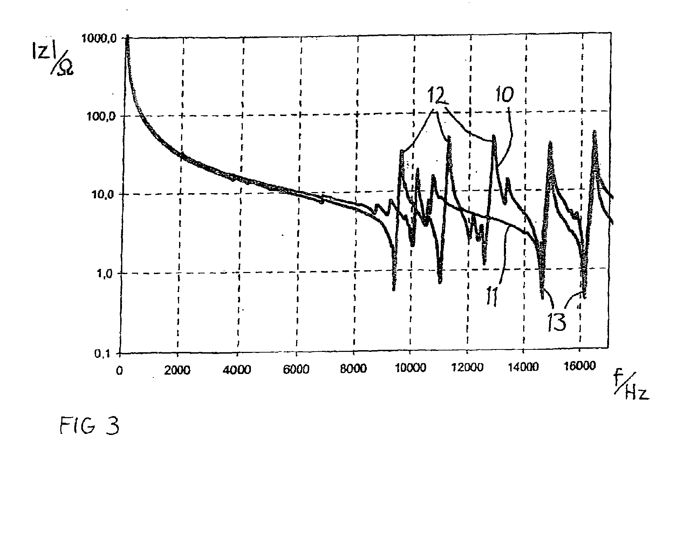

Die Figur 3 zeigt ein Diagramm eines Impedanzspektrums. Hierin ist der Absolutbetrag |z| der Impedanz in Ω (Ohm) über der Frequenz f in Hz (Hertz) aufgetragen. Eine vor der Optimierung gemessene Impedanzkurve 10 zeigt eine Mehrzahl von Parallelresonanzen 12 und Serienresonanzen 13 auf. In der nach einer Optimierung der Montage des Piezoaktuators aufgenommenen Impedanzkurve 11 treten die Resonanzen in größerem Frequenzabstand auf, und größere lokale Maxima und Minima der Impedanz treten nur bei hohen Frequenzen auf. Daraus lässt sich entnehmen, dass im Zuge der Optimierung das Auftreten von Biegeschwingungen erheblich verringert wurde.

Das beschriebene Verfahren hat den besonderen Vorteil, dass auftretende Transversalschwingungen in einer Weise detektiert werden, die es erlaubt, das Ausmaß von Biegeschwingungen während des Betriebes des Piezoaktuators beziehungsweise die durch eine Änderung der Montage erreichten Verbesserungen unmittelbar zu kontrollieren, und zwar während der Messung oder unmittelbar im Nachgang zu der Messung eines Kleinsignalspektrums, insbesondere des Impedanzspektrums, des montierten Piezoaktuators. Bei Abweichungen von einem gewünschten Zustand können relevante Montageparameter geändert werden, bis die Messung eine ausreichende Minimierung der Biegeschwingungen ausweist, oder der Piezoaktuator kann als Bauteil vollständig ausgetauscht werden. Ein weiterer Vorteil ist, dass das Verfahren unter Verwendung eines elektronischen Regelkreises durchgeführt werden kann und in einer solchen Ausgestaltung beispielsweise in einer elektronischen Wartungs- oder Diagnoseschaltung oder in einer automatischen Montageanlage implementiert werden kann, was eine schnelle, zuverlässige und kostengünstige Anwendung erlaubt. Ein Piezoaktuator, bei dem das Verfahren angewendet wird, kann zum Beispiel in einem für ein Kraftfahrzeug vorgesehenen Motor eingebaut sein oder montiert werden. Das Verfahren kann somit zu Überwachungszwecken im Injektor eines Kraftfahrzeugs eingesetzt werden, um beispielsweise frühzeitig unerwünschte und für den zuverlässigen Betrieb schädliche Biegeschwingungen zu erfassen.

### Bezugszeichenliste

- 1: Piezoaktor
- 2: Halterung
- 3: Längsrichtung
- 4: Longitudinalschwingung
- 5: Transversalschwingung
- 6: erster Verfahrensschritt
- 7: zweiter Verfahrensschritt
- 8: dritter Verfahrensschritt
- 9: Wiederholung von Verfahrensschritten
- 10: Impedanzkurve vor Optimierung
- 11: Impedanzkurve nach Optimierung
- 12: Parallelresonanz
- 13: Serienresonanz

## Patentansprüche

1. Verfahren zur Kontrolle von Biegeschwingungen eines Piezoaktuators, bei dem
- ein Kleinsignalspektrum (10, 11) eines zur Anregung von Longitudinalschwingungen (4) vorgesehenen und montierten Piezoaktuators (1) gemessen wird und
- aus Resonanzen (12, 13), die in dem Kleinsignalspektrum (10, 11) auftreten, eine Anregung einer Transversalschwingung (5) in dem Piezoaktuator (1) erfasst wird.

2. Verfahren nach Anspruch 1, bei dem
- der Piezoaktuator (1) in einer Längsrichtung (3), in der die Longitudinalschwingungen (4) angeregt werden, zwischen Halterungen (2) montiert wird,
- im Fall eines Auftretens einer unerwünscht starken Transversalschwingung (5) die Montage des Piezoaktuators (1) geändert wird und
- die Messung des Kleinsignalspektrums (10, 11) und die Änderung der Montage nach Bedarf wiederholt werden, bis aus Resonanzen (12, 13) in dem Kleinsignalspektrum (10, 11) erkannt wird, dass keine oder allenfalls eine unterhalb einer vorgegebenen Grenze liegende Transversalschwingung (5) angeregt wird.

3. Verfahren nach Anspruch 2, bei dem die Messung und die Änderung der Montage so oft wiederholt werden, bis Resonanzen (12, 13) in dem Kleinsignalspektrum (10, 11) allenfalls in einem vorgegebenen minimalen Frequenzabstand auftreten.

4. Verfahren nach Anspruch 2 oder 3, bei dem die Messung und die Änderung der Montage so oft wiederholt werden, bis Resonanzen (12, 13) in dem Kleinsignalspektrum (10, 11) allenfalls oberhalb einer vorgegebenen minimalen Frequenz auftreten.

5. Verfahren nach einem der Ansprüche 2 bis 4, bei dem zur Änderung der Montage die Position und/oder der Winkel des Piezoaktuators (1) bezüglich der Halterungen (2) geändert wird.

6. Verfahren nach einem der Ansprüche 2 bis 5, bei dem zur Änderung der Montage eine von den Halterungen (2) auf den Piezoaktuator (1) ausgeübte mechanische Spannung geändert wird.

7. Verfahren nach einem der Ansprüche 1 bis 6, bei dem als Kleinsignalspektrum (10, 11) der absolute Betrag der Impedanz |z| des Piezoaktuators (1) in Abhängigkeit von der Frequenz f einer angelegten Wechselspannung gemessen wird.

8. Verfahren nach Anspruch 7, bei dem Parallelresonanzen (12) und Serienresonanzen (13) des Piezoaktuators (1) bestimmt werden.

9. Verfahren nach einem der Ansprüche 1 bis 8, bei dem die Messung und Auswertung des Kleinsignalspektrums (10, 11) unter Einsatz eines elektronischen Regelkreises durchgeführt werden.

10. Verfahren nach einem der Ansprüche 1 bis 9, bei dem der Piezoaktuator (1) in einem für ein Kraftfahrzeug vorgesehenen Motor eingebaut ist oder montiert wird.

## Claims

1. Method for monitoring flexural vibrations of a piezoactuator, in which
- a small-signal spectrum (10, 11) of a piezoactuator (1) provided and mounted in order to excite longitudinal vibrations (4) is measured, and
- an excitation of a transverse vibration (5) in the piezoactuator (1) is detected from resonances (12, 13) occurring in the small-signal spectrum (10, 11).

2. Method according to Claim 1, in which
- the piezoactuator (1) is mounted between holders (2) in a longitudinal direction (3) in which the longitudinal vibrations (4) are excited,
- the mounting of the piezoactuator (1) is changed in the case of an occurrence of an undesirably strong transverse vibration (5), and
- the measurement of the small-signal spectrum (10, 11) and the change to the mounting are repeated as required until it is detected from resonances (12, 13) in the small-signal spectrum (10, 11) that no transverse vibration (5), or at most a transverse vibration (5) below a prescribed limit, is excited.

3. Method according to Claim 2, in which the measurement and the change in the mounting are repeated until resonances (12, 13) occur in the small-signal spectrum (10, 11) possibly at a prescribed minimum frequency spacing.

4. Method according to Claim 2 or 3, in which the measurement and the change in the mounting are repeated until resonances (12, 13) occur in the small-signal spectrum (10, 11), possibly above a prescribed minimum frequency.

5. Method according to one of Claims 2 to 4, in which the position and/or the angle of the piezoactuator (1) with reference to the holders (2) is changed in order to change the mounting.

6. Method according to one of Claims 2 to 5, in which a mechanical stress exerted by the holders (2) on the piezoactuator (1) is changed in order to change the mounting.

7. Method according to one of Claims 1 to 6, in which the absolute value of the impedance |z| of the piezoactuator (1) is measured as small-signal spectrum (10, 11) as a function of the frequency f of an applied AC voltage.

8. Method according to Claim 7, in which parallel resonances (12) and series resonances (13) of the piezoactuator (1) are determined.

9. Method according to one of Claims 1 to 8, in which the measurement and evaluation of the small-signal spectrum (10, 11) are carried out by using an electronic control loop.

10. Method according to one of Claims 1 to 9, in which the piezoactuator (1) is installed or mounted in an engine provided for a motor vehicle.

## Revendications

1. Procédé de contrôle des oscillations de flexion d'un actionneur piézoélectrique, selon lequel
- un spectre de faible signal (10, 11) d'un actionneur piézoélectrique (1) qui est conçu et monté pour exciter des oscillations longitudinales (4) est mesuré et
- une excitation d'une oscillation transversale (5) est détectée dans l'actionneur piézoélectrique (1) à partir des résonances (12, 13) qui se produisent dans le spectre de faible signal (10, 11)..

2. Procédé selon la revendication 1, selon lequel
- l'actionneur piézoélectrique (1) est monté entre des supports (2) dans une direction longitudinale (3) dans laquelle sont excitées les oscillations longitudinales (4),
- dans le cas où il se produit une forte oscillation transversale (5) indésirable, le montage de l'actionneur piézoélectrique (1) est modifié et
- la mesure du spectre de faible signal (10, 11) et la modification du montage sont répétés suivant le besoin jusqu'à ce que les résonances (12, 13) dans le spectre de faible signal (10, 11) permettent de détecter qu'aucune oscillation transversale (5) n'est excitée, ou tout au plus une oscillation transversale (5) inférieure à une limite prédéfinie.

3. Procédé selon la revendication 2, selon lequel la mesure et la modification du montage sont répétées suffisamment souvent, jusqu'à ce que les résonances (12, 13) dans le spectre de faible signal (10, 11) se produisent tout au plus dans un écart de fréquences minimal prédéfini.

4. Procédé selon la revendication 2 ou 3, selon lequel la mesure et la modification du montage sont répétées suffisamment souvent, jusqu'à ce que les résonances (12, 13) dans le spectre de faible signal (10, 11) se produisent tout au plus au-dessus d'une fréquence minimale prédéfinie.

5. Procédé selon l'une des revendications 2 à 4, selon lequel la modification du montage s'effectue en modifiant la position et/ou l'angle de l'actionneur piézoélectrique (1) par rapport aux supports (2).

6. Procédé selon l'une des revendications 2 à 5, selon lequel la modification du montage s'effectue en modifiant une contrainte mécanique exercée par les supports (2) sur l'actionneur piézoélectrique (1).

7. Procédé selon l'une des revendications 1 à 6, selon lequel le spectre de faible signal (10, 11) mesuré est la valeur absolue de l'impédance |z| de l'actionneur piézoélectrique (1) en fonction de la fréquence f d'une tension alternative appliquée.

8. Procédé selon la revendication 7, selon lequel les résonances parallèles (12) et les résonances série (13) de l'actionneur piézoélectrique (1) sont déterminées.

9. Procédé selon l'une des revendications 1 à 8, selon lequel la mesure et l'interprétation du spectre de faible signal (10, 11) sont effectuées en utilisant un circuit de régulation électronique.

10. Procédé selon l'une des revendications 1 à 9, selon lequel l'actionneur piézoélectrique (1) est installé ou monté dans un moteur conçu pour un véhicule automobile.
